# EUROPÄISCHE PATENTSCHRIFT

(11) **EP 0 284 910 B1**
(45) Veröffentlichungstag und Bekanntmachung des Hinweises auf die Patenterteilung: **26.05.1993**
(21) Anmeldenummer: 88104291.5
(22) Anmeldetag: 17.03.1988
(51) Int. Cl.: G02B 6/12, G02B 6/28

(54) **Integriert-optische Anordnung für die bidirektionale optische Nachrichten- oder Signalübertragung**
Integrated-optical device for bi-directional optical communications- or signal- transmission
Dispositif optique intégré pour transmission bidirectionnelle de signaux de communications optiques

(30) Priorität: 30.03.1987 DE 3710549
(43) Veröffentlichungstag der Anmeldung: 05.10.1988
(73) Patentinhaber: SIEMENS AKTIENGESELLSCHAFT, 80333 München (DE)
(72) Erfinder: Winzer, Gerhard, Dr.-Ing., D-8011 Putzbrunn (DE); Stoll, Lothar, Dipl.-Phys., D-8025 Unterhaching (DE); März, Reinhard, Dr.phil.nat., D-8000 München 80 (DE)

(56) Entgegenhaltungen:
- EP-A- 0 187 198
- GB-A- 2 170 322
- US-A- 4 084 130
- US-A- 4 116 530
- US-A- 4 136 928
- XEROX DISCLOSURE JOURNAL, Band 4, Nr. 3, Mai/Juni 1979, Seite 363; R.D. BURNHAM et al.: "Large collimated output beams from DBR lasers"
- Appl. Phys. Lett., vol. 24, no. 4, S. 194-196
- Unger, Opt. Nachrichtentechnik (Berlin 1976), S. 105-114

## Beschreibung

Die Erfindung betrifft eine integriert-optische Anordnung für die bidirektionale optische Nachrichten- oder Signalübertragung nach dem Oberbegriff des Patentanspruchs 1.

Eine Anordnung der genannten Art ist aus der DE-OS 35 00 327 (VPA 85 P 1004) bekannt. Bei dieser bekannten Anordnung besteht die richtungsselektive Koppeleinrichtung im wesentlichen aus einem auf der Wellenleiterstruktur ausgebildeten Bragg-Gitter, das derart gestaltet ist, daß es die vom Laser emittierte und am ersten Tor in die Wellenleiterstruktur eingekoppelte eine Wellenlänge λ₁ zum dritten Tor durchläßt oder umlenkt und daß es die am dritten Tor in die Wellenleiterstruktur eingekoppelte andere Wellenlänge λ₂ zum Detektor umlenkt bzw. durchläßt. Die Wellenleiterstruktur kann aus einem Schichtwellenleiter bestehen oder aus einer T-förmigen Streifenwellenleiterstruktur. Die bekannte Anordnung ist für kleine Kanalabstände, d.h. Abstände von weniger als 50 nm geeignet.

Aufgabe der Erfindung ist es, eine neuartige Gestaltung einer Anordnung der eingangs genannten Art anzugeben, die ebenfalls für kleine Kanalabstände geeignet ist und mit der eine Nebensprechdämpfung von mindestens 45 dB erreichbar ist.

Diese Aufgabe wird durch die im kennzeichnenden Teil des Patentanspruchs 1 angegebenen Merkmale gelöst.

Bei der erfindungsgemäßen Anordnung wird die geforderte und auch für die Praxis erforderliche Nebensprechdämpfung einerseits durch Ausnützen der Richtungsselektivität der Wellenleitergabel bzw. des Richtkopplers und andererseits durch die Filterwirkung des wellenlängenselektiven Filters erreicht, das insbesondere den Einsatz der Anordnung zur Übertragung bei kleinem Kanalabstand ermöglicht.

Besonders vorteilhaft ist es, wenn die Anordnung auf beiden Seiten einer Übertragungsstrecke in einer einheitlichen Technologie hergestellt werden kann. Sie läßt sich dabei mit den Technologien der integrierten Optik herstellen und ist für Glasfaserübertragungsstrecken im Teilnehmeranschlußbereich geeignet.

Das dritte Tor der Koppeleinrichtung der erfindungsgemäßen Anordnung ist meist durch die Endfläche eines Streifenwellenleiters definiert, an der ein hoher Brechzahlsprung vorhanden ist. In diesem Fall ist es wichtig, die erfindungsgemäße Anordnung nach Maßgabe des Anspruchs 2 zu gestalten, da die Intensität des vom Laser emittierten Lichts der einen Wellenlänge λ₁ um ein Vielfaches höher als die Intensität des durch eine lange Übertragungsstrecke zugeleiteten und gedämpften Lichts der anderen Wellenlänge λ₂ ist, die Intensität eines von einer unentspiegelten Endfläche reflektierten Anteils des Lichts der einen Wellenlänge λ₁ immer noch um ein Vielfaches größer als die Intensität des über die Übertragungsstrecke zugeführten Lichts der anderen Wellenlänge λ₂ sein kann und der reflektierte Anteil des Lichts der einen Wellenlänge λ₁ sowohl in den Laser zurück als auch auf das wellenlängenselektive Filter gelangt, das den Fotodetektor gegen das Licht des Lasers abschirmt.

Eine Wellenleitergabel und ein optischer Richtkoppler verursachen zumindest in Bezug auf die dem dritten Tor zugeführte andere Wellenlänge λ₂ im Hinblick auf den Anteil, der dem wellenlängenselektiven Filter und dem Detektor zugeleitet wird, einen Verlust von 3 dB, zumindest wenn gleiche Wellenleiter und symmetrischer Aufbau verwendet werden. Dieser Verlust kann beispielsweise durch asymmetrischen Aufbau verringert werden, beispielsweise indem der erste Gabelzweig der Wellenleitergabel im Querschnitt kleiner der Gabelstamm und der zweite Gabelzweig gemacht werden.

In viel stärkerem Maße als bei einer Wellenleitergabel läßt sich der Verlust bei Verwendung eines optischen Richtkopplers herabmindern, wenn dieser Richtkoppler ein wellenlängenselektiver Richtkoppler ist, wie er im Anspruch 3 angegeben ist. Im Zusammenhang mit dieser Ausgestaltung sei darauf hingewiesen, daß bei der erfindungsgemäßen Anordnung der Richtkoppler allein schon durch seine Richtungsselektivität für eine Trennung der Kanäle mit ebenso gutem Wirkungsgrad wie eine Wellenleitergabel sorgt. Seine Wellenlängenselektivität wird bei der Ausgestaltung nach Anspruch 3 nur genutzt, um eine Reduktion der Verluste zu erzielen. Dadurch kann der Richtkoppler gegenüber einer hochselektiven Variante erheblich kürzer ausgeführt werden, weil die Unterdrückung des Nebensprechens in dem nachgeschalteten wellenlängenselektiven Filter erfolgt.

Eine bevorzugte Ausgestaltung einer Anordnung nach Anspruch 3 ist im Anspruch 4 angegeben.

In Bezug auf die Y-förmige Wellenleitergabel sei darauf hingewiesen, daß dies nicht so zu verstehen ist, daß die Gabel nur zwei Gabelzweige aufweisen dürfte. Die Gabel könnte auch mehr als zwei Gabelzweige aufweisen. Wesentlich ist nur, daß zwei Gabelzweige vorhanden sind, von denen einer dem ersten und der andere dem zweiten Tor zugeordnet ist und die sich in einer Gabelwurzel mit einem Gabelstamm vereinigen.

Eine besonders bevorzugte Ausgestaltung einer erfindungsgemäßen Anordnung ist im Anspruch 5 angegeben, nach der die wellenlängenselektive Filtereinrichtung aus einem Bragg-Gitter besteht.

Bevorzugte Ausgestaltungen der Anordnung nach Anspruch 5 gehen aus den Ansprüchen 6 und 7 hervor.

Da das Bragg-Gitter nicht auf die andere Wellenlänge λ₂ des von der Strecke ankommenden Lichtes, sondern auf die eine Wellenlänge λ₁ des Lasers, der sich auf dem gleichen Substrat befindet, abgestimmt ist, sind polarisationsunabhängige Bauteile nicht nötig, weil der Laser nur in der TE-Polarisation anschwingt. Darüberhinaus bietet diese Ausgestaltung oder Anordnung den Vorteil, daß die Bausteine für eine Übertragungsstrecke in einem bestimmten Bereich frei kombiniert werden können. Der kleinste mögliche Abstand der Wellenlänge λ₁ und λ₂ wird dabei durch die Breite des Sperrbandes des Bragg-Gitters bestimmt, nach oben werden die möglichen Wellenlängenabstände durch das Einsetzen der Abstrahlung des Bragg-Gitters auf der kurzwelligen Seite begrenzt.

Eine in Bezug auf die Herstellung besonders vorteilhafte Ausgestaltung der erfindungsgemäßen Anordnung ist im Anspruch 8 angegeben.

Bei Herstellung einer erfindungsgemäßen Anordnung durch Epitaxie kann die im Anspruch 8 angegebene gemeinsame Schicht eine Epitaxieschicht sein und die beiden Gitter können dann ohne eine dazwischenliegende Epitaxie hergestellt werden, so daß die Anzahl der notwendigen Prozeßschritte deutlich reduziert werden kann.

Bei der in Anspruch 9 angegebenen Ausgestaltung der Anordnung nach Anspruch 8 können die beiden notwendigen Gitter auch noch in einem einzigen Verfahrensschritt hergestellt werden.

Eine bevorzugte und vorteilhafte Ausgestaltung einer Anordnung nach Anspruch 8 oder 9 geht aus dem Anspruch 10 hervor, von der insbesondere die Anordnung nach Anspruch 10 zweckmäßigerweise so ausgestaltet ist, wie es im Anspruch 11 angegeben ist. Die dort angegebene Zwischenschicht ist eingeführt, damit zumindest das als Filter verwendete Bragg-Gitter nach dem Ätzen der Laserstruktur nicht erneut epitaktisch überwachsen werden muß.

Die Erfindung wird anhand der Figuren in der nachfolgenden Beschreibung näher erläutert. Von den Figuren zeigen:
- Figur 1: eine Draufsicht auf eine Anordnung mit einer Wellenleitergabel als richtungsselektive Koppeleinrichtung,
- Figur 2: einen vertikalen Schnitt durch die Anordnung nach Figur 1, wobei die linke Hälfte der Figur 2 nur den durch die Schnittlinie A - A in Figur 1 angedeuteten Teil und die rechte Hälfte der Figur 2 nur den durch die Schnittlinie B - B in Figur 1 angedeuteten Teil des Schnittes zeigt,
- Figur 3: eine Draufsicht auf eine Anordnung mit einem wellenlängenselektiven optischen Richtkoppler als richtungsselektive Koppeleinrichtung,
- Figur 4: eine Draufsicht auf eine Anordnung, bei welcher die beiden Gitter aus einem einzigen fächerförmigen Gitter bestehen, das auf einer Epitaxieschicht aufgebracht ist, und
- Figur 5: einen vertikalen Schnitt durch die Anordnung nach Figur 4, wobei der linke Teil der Figur 5 nur den durch die Schnittlinie C - C in Figur 4 angedeuteten Teil und die rechte Hälfte der Figur 5 nur den durch die Schnittlinie D - D in Figur 4 angedeuteten Teil des Schnitts zeigt.

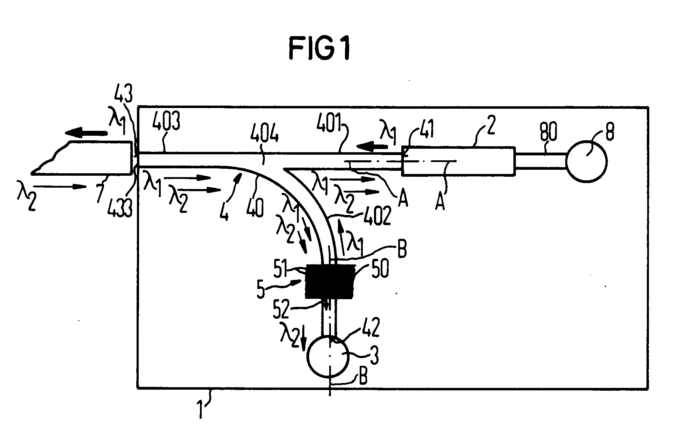

Bei der Anordnung nach Figur 1 sind auf dem gemeinsamen Substrat 1 der Halbleiterlaser 2, der optische Detektor 3 und die Wellenleitergabel 40 als richtungsselektive optische Koppeleinrichtung 4, das Bragg-Gitter 50 als wellenlängenselektives Filter 5 und eine Monitordiode 8 zur Überwachung der Ausgangsleistung des Lasers 2 integriert.

Die Wellenleitergabel 40 ist aus Streifenwellenleitern gebildet, wobei der vom ersten Tor 41 beim Laser 2 zur Gabelwurzel 404 führende Gabelzweig 401 und der von dort zum dritten Tor 43 führende Gabelstamm 403 aus einem durchgehenden geradlinigen Streifenwellenleiter besteht, während der zum zweiten Tor 42 beim Detektor 3 führende andere Gabelzweig 402 aus einem bei der Gabelwurzel 404 abzweigenden und gekrümmt verlaufenden Streifenwellenleiter besteht. In die Oberfläche dieses Streifenwellenleiters ist das Bragg-Gitter geätzt oder anderweitig erzeugt.

Das dritte Tor 43 der Wellenleitergabel 40 ist durch die Endfläche 433 des geradlinig verlaufenden Streifenwellenleiters 401, 403 am Ende des Gabelstammes 403 definiert. An diese Endfläche 433 ist eine Übertragungsfaser 7 angekoppelt, in der die vom Halbleiterlaser ausgesandte, über das erste Tor 41 in den geradlinig verlaufenden Streifenwellenleiter 401, 403 zum dritten Tor 43 geleitete eine Wellenlänge λ₁ fortgeleitet wird.

Die durch die Faser 7 der Anordnung zugeleitete andere Wellenlänge λ₂ wird über das dritte Tor 43 in den Gabelstamm 403 eingekoppelt und breitet sich darin ebenso wie ein an der Endfläche 433 reflektierter Anteil des Lichts der einen Wellenlänge λ₁ in Richtung Gabelwurzel 404 aus, wo eine Intensitätsaufteilung derart stattfindet, daß sich ein Teil der Intensität der beiden Wellenlängen in dem einen Gabelzweig 401 zum ersten Tor 41 und ein anderer Teil - typischerweise etwa die Hälfte - in dem anderen Gabelzweig 402 zum Bragg-Gitter 50 ausbreitet.

Das Bragg-Gitter 50 ist so bemessen, daß die eine Wellenlänge λ₁ an ihm reflektiert wird und sich in dem anderen Gabelzweig 402 zur Gabelwurzel 404 und von dort zum dritten Tor 43 zurück ausbreitet, während die andere Wellenlänge λ₂ zum zweiten Tor 42 durchgelassen wird, wo sie zum Detektor 3 ausgekoppelt und dann detektiert werden kann.

Das vom Laser 2 ausgesandte und zum dritten Tor 43 gelangende Licht der einen Wellenlänge λ₁ hat üblicherweise eine ungleich größere Intensität als das Licht der anderen Wellenlänge λ₂, das durch die Faser 7 dem dritten Tor 43 zugeleitet wird, weil dieses Licht in der Übertragungsstrecke meist sehr stark gedämpft ankommt. Da die Endfläche 433 typischerweise auch einen sehr starken Brechzahlsprung aufweist und dadurch auch ein hoher Anteil des Lichts der einen Wellenlänge λ₁ an dieser Endfläche 433 reflektiert wird, muß diese Endfläche 433 hochwertig entspiegelt werden, damit die Intensität des reflektierten Anteils zumindest in der Größenordnung des zugeleiteten Lichts der anderen Wellenlänge λ₂ liegt. Als Richtwert kann angegeben werden, daß an der Endfläche 433 höchstens ein Bruchteil des Lichts der einen Wellenlänge λ₁ reflektiert werden darf, der in der Größenordung von einem Promille liegt.

Der Monitordetektor 8 ist auf der vom ersten Tor 41 abgekehrten Seite des Halbleiterlasers 2 angeordnet und durch ein kurzes Stück Streifenwellenleiter 80 mit dem Halbleiterlaser 2 verbunden.

Der Detektor 3 und der Monitordetektor 8 können Fotodioden sein.

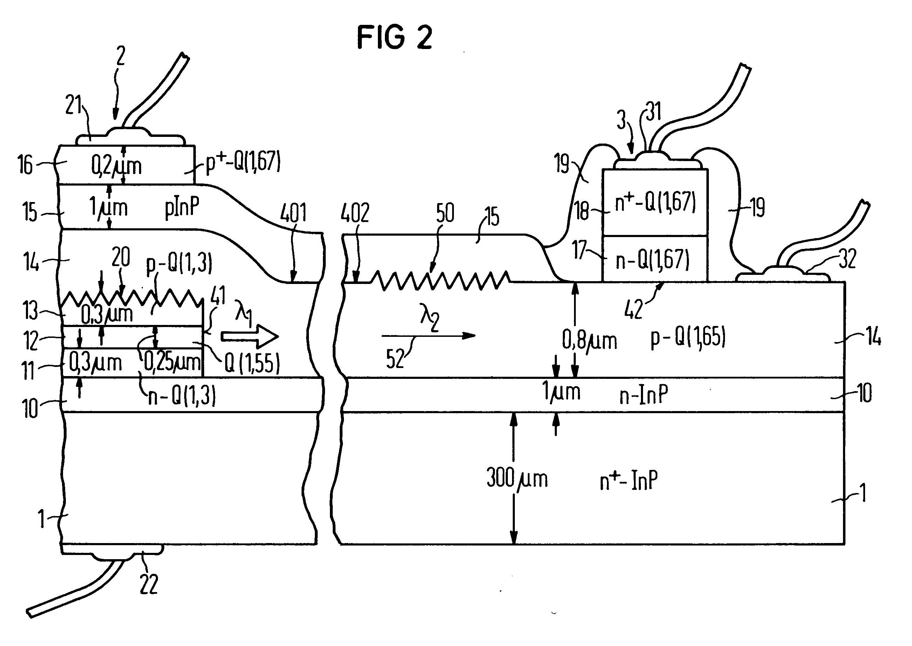

Ein konkretes Ausführungsbeispiel der Anordnung nach Figur 1 ist in der Figur 2 in einem Vertikalschnitt dargestellt, wobei nur die im Hinblick auf die Herstellung und die Kopplung der Wellenleitergabel 40 an den Halbleiterlaser 2 und den Detektor 3 sowie die Ausbildung des Bragg-Gitters 50 interessanten Teile des vertikalen Schnitts dargestellt sind. Es sind dies die beiden vertikalen Schnitte längs und im Bereich der Schnittlinie A - A und B - B, von denen in der Figur 2 der zur Linie A - A gehörende links und der zur Linie B - B gehörende rechts von dem trennenden Zwischenraum dargestellt ist.

Danach sind bei dem Ausführungsbeispiel nach Figur 2 auf einem n⁺-dotiertem Substrat 1 aus InP von 300 µm Dicke eine epitaktische Pufferschicht 10 aus n-dotiertem InP von 1 µm Dicke und darauf eine Epitaxieschicht 14 aus p-dotiertem quaternärem Material mit einer Gap-Wellenlänge von 1,05 und einer Dicke von 0,8 µm aufgebracht. Auf der Schicht 14 befindet sich eine weitere p-dotierte Epitaxieschicht aus InP von 1 µm Dicke.

Der im linken Teil der Figur 2 befindliche DFB-Laser 2 ist im wesentlichen dadurch gebildet, daß zwischen der Schicht 10 und der Schicht 14 bereichsweise ein Schichtenstapel aus drei Schichten 11 bis 13 angeordnet ist, von denen die Schicht 13 das Bragg-Gitter 20 des Lasers trägt.

Von den drei Schichten 11 bis 13, die ebenfalls Epitaxieschichten sind, ist die Schicht 11 unmittelbar auf der Schicht 10 aufgebracht und besteht aus n-dotiertem, quaternärem Material mit einer Gap-Wellenlänge von 1,3 und einer Dicke von 0,3 µm. Auf der Schicht 11 ist die Schicht 12 aufgebracht, welche die laseraktive Schicht bildet und aus undotiertem quaternärem Material mit einer Gap-Wellenlänge von 1,55 und einer Dicke von 0,25 µm besteht.

Auf der Schicht 12 ist die Schicht 13 aufgebracht, die aus p-dotiertem quaternärem Material und einer Gap-Wellenlänge von 1,3 und einer Dicke von 0,3 µm besteht und in deren Oberfläche das Bragg-Gitter 20 eingeätzt ist.

Die Schichten 11 bis 13 und das Gitter 20 werden vor dem Aufbringen der Schichten 14 hergestellt.

Zur Vervollständigung der Laserdiode ist auf der Schicht 15 über den drei Schichten 11 bis 13 eine p⁺-dotierte quaternäre Schicht mit einer Gap-Wellenlänge von 1,67 und einer Dicke von 0,2 µm aufgebracht, die mit einem Kontakt 21 kontaktiert ist. Der Gegenkontakt 22 dazu ist auf der Unterseite des Substrats 1 unterhalb der drei Schichten 11 bis 13 aufgebracht. Das vom Laser 2 emittierte Licht der einen Wellenlänge λ₁ tritt aus den Stirnflächen der Schicht 12 aus und tritt von einer dieser beiden Stirnflächen unmittelbar in die Schicht 14 über, welche die Wellenleitergabel 40 bildet oder enthält. Demnach bildet diese Stirnfläche auch das erste Tor 41 der Wellenleitergabel 40.

Der im rechten Teil der Figur 2 befindliche Detektor 3 besteht aus einer Fotodiode, die im wesentlichen aus der Schicht 14, einer darauf aufgebrachten n-dotierten quaternären Schicht 17 mit einer Gap-Wellenlänge von 1,67 und einer auf dieser Schicht aufgebrachten n⁺-dotierten quaternären Schicht 18, mit derselben Gap-Wellenlänge von 1,67.

Von den beiden Kontakten der Diode 3 ist der Kontakt 31 auf der Schicht 18 und der andere Kontakt 32 auf der p-dotierten

Schicht 14 aufgebracht, die in dem rechten Teil der Figur 2 den anderen Gabelzweig 402 der Wellenleitergabel 40 als Streifenwellenleiter bildet oder enthält. Beispielsweise können die Streifenwellenleiter der Wellenleitergabel 40 als Rippenwellenleiter aus der Schicht 14 herausgeätzt sein.

Mit 19 ist eine die Diode 3 umgebende Passivierungsschicht bezeichnet, die beispielsweise aus Silziumnitrid bestehen kann.

Das zweite Tor 42 ist durch die Grenzfläche zwischen der Schicht 17 und der Schicht 14 definiert.

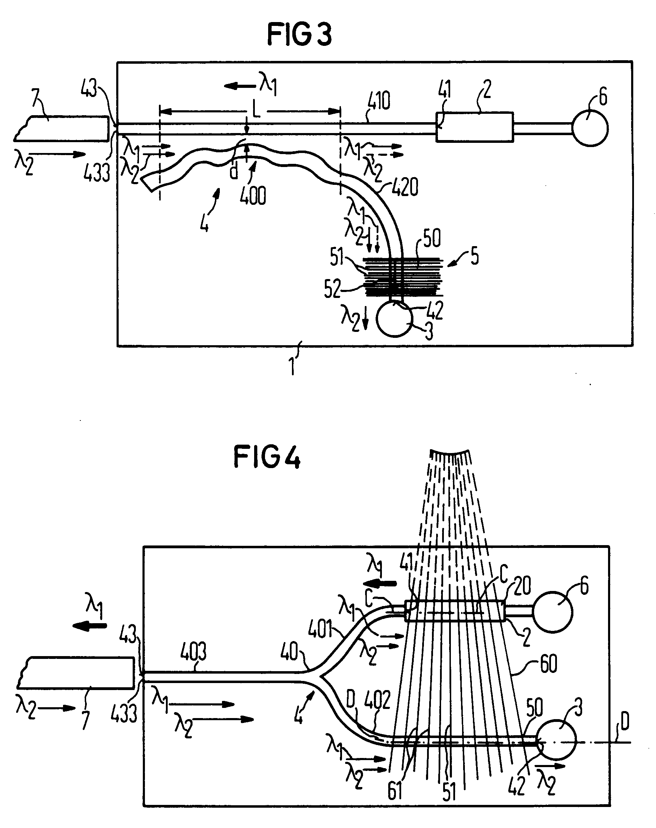

Die Ausführungsform nach Figur 3 unterscheidet sich von der Ausführungsform nach den Figuren 1 und 2 dadurch, daß anstelle der Wellenleitergabel ein Richtkoppler 400 mit einer Koppelstrecke L verwendet ist.

Dieser Richtkoppler 400 besteht aus einem zwischen dem ersten Tor 41 und dem dritten Tor 43 geradlinig verlaufenden Streifenwellenleiter 410 und aus einem in der Koppelstrecke L in einem geringen Abstand d von diesem Wellenleiter 110 angeordneten zweiten Wellenleiter 420, der in der Koppelstrecke L wellenförmig verläuft und zu dem zweiten Tor 42 führt. Der außerhalb der Koppelstrecke verlaufende Abschnitt des zweiten Wellenleiter 420, auf dem das Bragg-Gitter 50 aufgebracht ist, entspricht dem anderen Gabelzweig 402 der Wellenleitergabel 40 in der Ausführungsform nach den Figuren 1 und 2. Das auf der linken Seite der Koppelstrecke L befindliche Ende 421 des zweiten Wellenleiters 420 ist gegen einen Lichteintritt von außen abgeschirmt. Der Richtkoppler 400 wirkt als wellenlängenselektiver Richtkoppler derart, daß die Wellenlänge λ₁ im wesentlichen nur zwischen den Toren 41 und 43 und die Wellenlänge λ₂ im wesentlichen nur zwischen den Toren 43 und 42 übertragen wird. Dadurch sind die Verluste des Kopplers erheblich reduziert.

Ansonsten ist die Ausführungsform nach Figur 3 so aufgebaut, wie die Ausführungsform nach den Figuren 1 und 2.

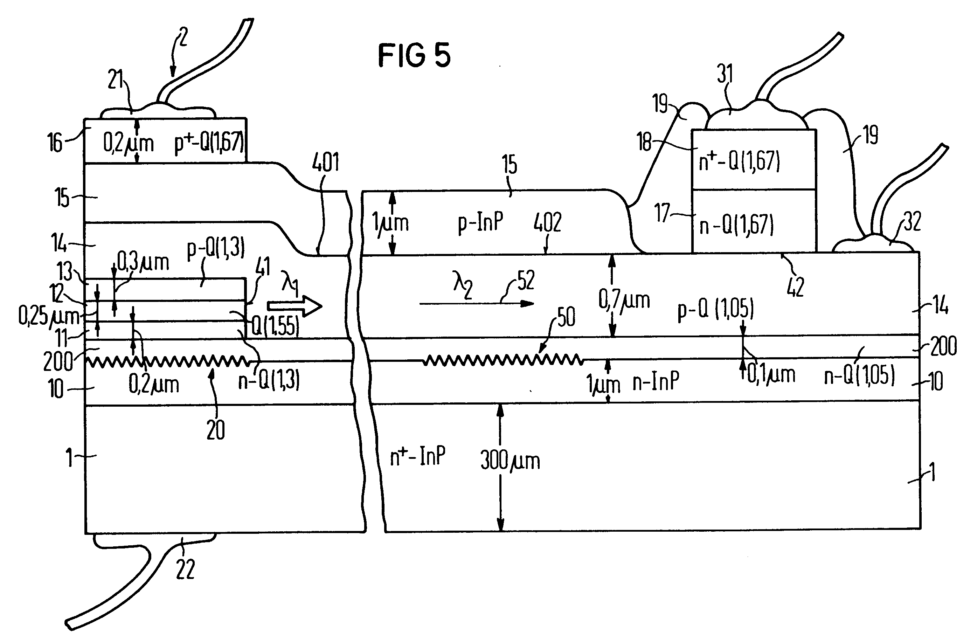

Die Ausführungsform nach den Figuren 4 und 5 unterscheidet sich von der Ausführungsform nach den Figuren 1 und 2 im wesentlichen dadurch, daß das Bragg-Gitter 20 des Lasers und das Bragg-Gitter 50, welches das wellenlängenselektive Filter 5 bildet, auf der gemeinsamen Pufferschicht 10 ausgebildet sind, die das Substrat 1 von der Schicht 14 trennt. Das Bragg-Gitter 20 des Lasers 2 befindet sich in diesem Fall unterhalb der drei Schichten 11 bis 13 des Lasers. Darüber hinaus bestehen das Gitter 20 des Lasers 2 und das Bragg-Gitter 50 aus einem einzigen Gitter 60, dessen Gitterlinien 51, 61 vom Gitter 20 in Richtung zum Bragg-Gitter 50 fächerförmig auseinanderstreben. Dadurch können die beiden Gitter 20 und 50 in einem einzigen Verfahrensschritt hergestellt werden.

Die beiden Gabelzweige 401 und 402 der Wellenleitergabel 40 verlaufen im Bereich der beiden Gitter 20 und 50 parallel zueinander. Anstelle einer Wellenleitergabel 40 könnte auch ein Richtkoppler, beispielsweise der Richtkoppler 400 nach Figur 3 verwendet werden.

Die zusätzliche n-dotierte Quaternärschicht 200 mit der Gap-Wellenlänge 1,05 und einer Dicke von 0,1 µm ist eingeführt, damit das Bragg-Gitter 50 nach dem Ätzen der Schichten 11 bis 13 des Lasers 2 nicht erneut epitaktisch überwachsen werden muß.

Ansonsten entspricht die Anordnung nach den Figuren 4 und 5 der Anordnung nach den Figuren 1 und 2.

Im übrigen ist in den Figuren 2 und 5 eine Quaternärschicht durch Q gekennzeichnet. Die Gap-Wellenlänge, welche die Brechzahl der betreffenden Quaternärschicht Q bestimmt, ist in Klammern angegeben. Außerdem ist die p- und n-Dotierung in den genannten Figuren angegeben, wobei ein hochgestelltes + auf relativ starke Dotierung hinweist.

Eine Anordnung mit den in den Figuren 2 und 5 angegebenen Bemessungen läßt eine Sperrbandbreite von 1 bis 2 nm und einem Wellenlängenabstand von 15 bis 20 nm bis zum Beginn der Abstrahlung des Bragg-Gitters 50 erwarten.

Die vorstehend und in den Figuren 2 und 5 in Klammern stehenden Zahlenangeben bezüglich der Gap-Wellenlänge bedeuten µm. So bedeutet beispielsweise die Gap-Wellenlänge von 1,05 der Schicht 14 in den Figuren 2 und 5 eine Gap-Wellenlänge von 1,05 µm.

## Patentansprüche

1. Integriert-optische Anordnung für die bidirektionale optische Nachrichten- oder Signalübertragung,
wobei auf einem gemeinsamen Substrat (1)
ein Halbleiterlaser (2)
ein optischer Detektor (3) und
eine richtungsselektive Koppeleinrichtung (4) mit einer Wellenleiterstruktur (40; 400) integriert sind,
wobei die Koppeleinrichtung (4) drei Tore (41, 42, 43) aufweist, von denen ein erstes (41) an den Laser (1) und ein zweites (42) an den Detektor (3) gekoppelt ist, und
wobei die Koppeleinrichtung (4) derart ausgebildet ist, daß eine vom Laser (1) in das erste Tor (41) eingekoppelte Wellenlänge (λ₁) auf das dritte (43) der drei Tore (41, 42, 43) und nicht oder zumindest nicht wesentlich auf das zweite Tor (42) übertragen wird und daß eine in das dritte Tor (43) eingekoppelte andere Wellenlänge (λ₂) auf das zweite Tor (42) übertragen wird, **dadurch gekennzeichnet,** daß die Koppeleinrichtung (4) entwedes aus
einer Y-förmigen Wellenleitergabel (40) besteht, von der ein Gabelzweig (401) dem ersten (41), der andere Gabelzweig (402) dem zweiten (42) und der Gabelstamm (403) dem dritten Tor (43) zugeordnet ist, oder aus
einem optischen Richtkoppler (400) besteht, der auf einer Seite einer Koppelstrecke (L) zwei Tore aufweist, von denen eines das erste (41) und das andere das zweite Tor (42) der Koppeleinrichtung (4) bildet, der auf der anderen Seite der Koppelstrecke (L) ein das dritte Tor (43) der Koppeleinrichtung (4) bildendes Tor aufweist, und der so ausgebildet ist, daß über die Koppelstrecke (L) zwischen dem ersten (41) und dritten Tor (43) die eine Wellenlänge (λ₁) und zwischen dem dritten (43) und zweiten Tor (42) die andere Wellenlänge (λ₂) übergekoppelt wird, und
daß auf oder in einem zum Detektor (3) führenden Wellenleiter (402; 420) ein wellenlängenselektives Filter (5) angeordnet ist, das die eine Wellenlänge (λ₁) sperrt, für die andere Wellenlänge (λ₂) dagegen durchlässig ist.

2. Anordnung nach Anspruch 1, **dadurch gekennzeichnet,** daß eine das dritte Tor (43) der Wellenleitergabel (40) oder des Richtkopplers (400) bildende Endfläche (433) eines den Gabelstamm (403) der Wellenleitergabel (40) bildenden oder in die Koppelstrecke (L) des Richtkopplers (400) führenden Wellenleiters (430) derart entspiegelt ist, daß höchstens noch ein Bruchteil der in diesem Wellenleiter (403; 430) zugeführten einen Wellenlänge (λ₁) reflektiert wird, der in der Größenordnung von einem Promille liegt.

3. Anordnung nach Anspruch 1 oder 2, **dadurch gekennzeichnet,** daß der Richtkoppler (400) ein wellenlängenselektiver Richtkoppler ist, der so ausgebildet ist, daß durch die Koppelstrecke (L) zwischen dem ersten (41) und dritten Tor (43) die eine (λ₁) und nicht oder zumindest nicht wesentlich die andere Wellenlänge (λ₂) und zwischen dem dritten (43) und zweiten Tor (42) die andere (λ₂) und nicht oder zumindest nicht wesentlich die eine Wellenlänge (λ₁) übertragbar ist.

4. Anordnung nach Anspruch 3, **dadurch gekennzeichnet,** daß der Richtkoppler (400) einen in der Koppelstrecke (L) geradlinig verlaufenden und zwischen dem ersten Tor (41) und dritten Tor (43) der Koppeleinrichtung (4) geschalteten Wellenleiter (410) und einen in der Koppelstrecke (L) in einem geringen Abstand (d) von dem dort geradlinig verlaufenden Wellenleiter (410) angeordneten zweiten Wellenleiter (420) aufweist, der in der Koppelstrecke (L) wellenförmig verläuft und zu dem zweiten Tor (42) führt.

5. Anordnung nach einem der vorhergehenden Ansprüche, **dadurch gekennzeichnet,** daß die wellenlängenselektive Filtereinrichtung (5) aus einem an dem zu dem Detektor (3) führenden Wellenleiter (402; 420) ausgebildeten Bragg-Gitter (50) besteht.

6. Anordnung nach Anspruch 5, **dadurch gekennzeichnet,** daß das Bragg-Gitter (50) zumindest eine Gitterlinie (51) aufweist, die senkrecht zur Ausbreitungsrichtung (52) des in dem zum Detektor (3) führenden Wellenleiter (402; 420) geleiteten Lichts verlaufen.

7. Anordnung nach Anspruch 5 oder 6, **dadurch gekennzeichnet,** daß das Bragg-Gitter (50) auf dem als Wellenleiter ausgebildeten anderen Gabelzweig (402) der Wellenleitergabel (40) oder dem zweiten Wellenleiter (420) des Richtkopplers (400) außerhalb von dessen Koppelstrecke (L) angeordnet ist.

8. Anordnung nach einem der Ansprüche 5 bis 7, **dadurch gekennzeichnet,** daß der Laser (2) ein DFB-Laser mit einem optischen Gitter (20) ist, und daß das Gitter (20) des Lasers (2) und das Bragg-Gitter (50) an dem zum Detektor (4) führenden Wellenleiter (402) an einer gemeinsamen Schicht (10 oder 11) auf oder über dem Substrat (1) ausgebildet sind.

9. Anordnung nach Anspruch 8, **dadurch gekennzeichnet,** daß das Gitter (20) des Lasers (2) und das Bragg-Gitter (50) an dem zum Detektor (3) führenden Wellenleiter (402) aus einem einzigen Gitter (60) besteht, dessen Gitterlinien (51, 61) vom Gitter (20) des Lasers (2) in Richtung zum Bragg-Gitter (50) fächerförmig auseinanderstreben.

10. Anordnung nach Anspruch 8 oder 9, **dadurch gekennzeichnet,** daß das Gitter (20) des Lasers (2) und das an den zum Detektor (3) führenden Wellenleiter (402) ausgebildete Bragg-Gitter (50) auf einer Pufferschicht (10) ausgebildet sind, die das Substrat (1) von einer Schicht (14) trennt, welche die Wellenleiter (401, 402, 403; 420, 430) der Anordnung enthält oder bildet, und daß eine laseraktive Schicht (13) des Lasers über seinem Gitter (20) angeordnet ist.

11. Anordnung nach einem der Ansprüche 8 bis 10, insbesondere nach Anspruch 10, **dadurch gekennzeichnet,** daß zwischen einer zu ätzenden Schichtstruktur (11, 12, 12) des Lasers (2) und dem oder den Gittern (60; 20, 50) eine Zwischenschicht (200) vorgesehen ist.

## Claims

1. Integrated optical arrangement for bidirectional optical message or signal transmission, a semiconductor laser (2), an optical detector (3) and a directionally selective coupling device (4) having a waveguide structure (40; 400) being integrated on a common substrate (1), the coupling device (4) having three ports (41, 42, 43) of which a first (41) is coupled to the laser (1) and a second (42) is coupled to the detector (3), and the coupling device (4) being constructed such that a wavelength (λ₁) coupled from the laser (1) into the first port (41) is transmitted to the third (43) of the three ports (41, 42, 43) and not, or at least not substantially, to the second port (42), and that another wavelength (λ₂) coupled into the third port (43) is transmitted to the second port (42), characterised in that the coupling device (4) comprises either a Y-shaped waveguide fork (40) of which one fork branch (401) is assigned to the first (41), the other fork branch (402) is assigned to the second (42) and the fork stem (403) is assigned to the third (43) port, or comprises an optical directional coupler (400) which has on one side of a link (L) two ports of which one forms the first (41) and the other the second (42) port of the coupling device (4), which has on the other side of the link (L) a port forming the third port (43) of the coupling device (4), and which is constructed such that one wavelength (λ₁) is transferred between the first (41) and third (43) ports via the link (L) and the other wavelength (λ₂) is transferred via the link (L) between the third (43) and second (42) ports, and there is arranged on or in a waveguide (402; 420) leading to the detector (3) a wavelength-selective filter (5) which blocks one wavelength (λ₁) while passing the other wavelength (λ₂).

2. Arrangement according to Claim 1, characterised in that an end face (433), forming the third port (43) of the waveguide fork (40) or of the directional coupler (400), of a waveguide (430) forming the fork stem (403) of the waveguide fork (40) or leading into the link (L) of the directional coupler (400) is coated in such a way that of the wavelength (λ₁) fed in this waveguide (403; 430) at most only a fraction of the order of magnitude of one part per thousand is reflected.

3. Arrangement according to Claim 1 or 2, characterised in that the directional coupler (400) is a wavelength-selective directional coupler which is constructed such that it is possible to transmit one (λ₁) and not, or at least not substantially the other (λ₂) wavelength through the link (L) between the first (41) and third (43) ports, and to transmit the other (λ₂) and not, or at least not substantially, the first (λ₁) wavelength between the third (43) and second (42) port.

4. Arrangement according to Claim 3, characterised in that the directional coupler (400) has a waveguide (410), which extends rectilinearly in the link (L) and is connected between the first port (41) and third port (43) of the coupling device (4), and a second waveguide (420) which is arranged in the link (L) at a slight distance (d) from the waveguide (410) extending rectilinearly there, extends in an undulating fashion in the link (L), and leads to the second port (42).

5. Arrangement according to one of the preceding claims, characterised in that the wavelength-selective filter device (5) comprises a Bragg grating (50) constructed on the waveguide (402; 420) leading to the detector (3).

6. Arrangement according to Claim 5, characterised in that the Bragg grating (50) has at least one grating line (51) which extends perpendicular to the propagation direction (52) of the light guided in the waveguide (402; 420) leading to the detector (3).

7. Arrangement according to Claim 5 or 6, characterised in that the Bragg grating (50) is arranged on the other fork branch (402), which is constructed as a waveguide, of the waveguide fork (40), or on the second waveguide (420) of the directional coupler (400) outside the link (L) thereof.

8. Arrangement according to one of Claims 5 to 7, characterised in that the laser (2) is a DFB laser having an optical grating (20), and in that the grating (20) of the laser (2) and the Bragg grating (50) on the waveguide (402) leading to the detector (4) are constructed on a common layer (10 or 11) on or over the substrate (1).

9. Arrangement according to Claim 8, characterised in that the grating (20) of the laser (2) and the Bragg grating (50) on the waveguide (402) leading to the detector (3) comprise a single grating (60) whose grating lines (51, 61) diverge in the shape of a fan from the grating (20) of the laser (2) in the direction of the Bragg grating (50).

10. Arrangement according to Claim 8 or 9, characterised in that the grating (20) of the laser (2) and the Bragg grating (50) constructed on the waveguide (402) leading to the detector (3) are constructed on a buffer layer (10) which separates the substrate (1) from a layer (14) which contains or forms the waveguides (401, 402, 403; 420, 430) of the arrangement, and in that a laser-active layer (13) of the laser is arranged over its grating (20).

11. Arrangement according to one of Claims 8 to 10, particularly according to Claim 10, characterised in that an intermediate layer (200) is provided between a layer structure (11, 12, 13), which is to be etched, of the laser (2) and the grating or gratings (60; 20, 50).

## Revendications

1. Dispositif optique intégré pour la transmission optique bidirectionnelle d'informations ou de signaux,
du type dans lequel sont intégrés, dans un substrat (1) commun,
un laser (2) à semiconducteurs,
un détecteur (3) optique et
un dispositif de couplage (4) à sélection de direction et à structure en guide d'onde (40,400),
du type dans lequel le dispositif de couplage (4) comporte trois portes (41,42,43) parmi lesquelles une première porte (41) est couplée au laser (1) et une deuxième porte (42) est couplée au détecteur (3), et
du type dans lequel le dispositif de couplage (4) est réalisé de telle sorte qu'une (première) longueur d'onde (λ₁) envoyée par le laser (1) dans la première porte (41), est transmise à la troisième (43) des trois portes (41,42,43) et n'est pas ou, du moins, n'est pratiquement pas transmise à la deuxième porte (42) et qu'une seconde longueur d'onde (λ₂) envoyée dans la troisième porte (43), est transmise à la deuxième porte (42), caractérisé en ce que
le dispositif de couplage (4) est constitué
soit par une fourche de guide d'onde (40) en forme de Y, dont une première branche de fourche (401) est associée à la première porte (41), l'autre (la seconde) branche de fourche (402) est associée à la deuxième porte (42) et le corps de fourche (403) est associé à la troisième porte (43),
soit par un coupleur optique directif (400) qui comporte, d'un côté d'une voie de couplage (L), deux portes dont l'une constitue la première porte (41) du dispositif de couplage et l'autre constitue la deuxième porte (42) du dispositif de couplage, qui comporte, de l'autre côté de la voie de couplage (L), une porte constituant la troisième porte (43) du dispositif de couplage (4), ledit coupleur directif étant réalisé, de telle sorte que, par l'intermédiaire de la voie de couplage (L), la première longueur d'onde (λ₁) est couplée entre la première porte (41) et la troisième porte (43), alors que la seconde longueur d'onde (λ₂) est couplée entre la troisième porte (43) et la deuxième porte (42) et
en ce que, sur ou dans un guide d'onde (402,420) menant au détecteur (3), est prévu un filtre (5) à sélection de longueur d'onde qui bloque la première longueur d'onde (λ₁), mais qui, en revanche, laisse passer la seconde longueur d'onde (λ₂).

2. Dispositif selon la revendication 1, caractérisé en ce qu'une face d'extrémité (433) d'un guide d'onde (430) formant le corps de fourche (403) de la fourche du guide d'onde (40) ou menant à la voie de couplage (L) du coupleur directif (400), et qui forme la troisième porte (43) de la fourche de guide d'onde (40) ou du coupleur directif (400), est dépourvue de capacité réfléchissante au point qu'au maximum une fraction de la première longueur d'onde (λ₁) envoyée dans ce guide d'onde (403,430), est réfléchie dans un ordre de grandeur de un pour mille.

3. Dispositif selon la revendication 1 ou 2, caractérisé en ce que le coupleur directif (400) est un coupleur directif à sélection de longueur d'onde qui est réalisé de telle sorte que, à travers la voie de couplage (L), la première longueur d'onde (λ₁) est susceptible d'être transmise entre la première porte (41) et la troisième porte (43), la seconde longueur d'onde (λ₂) ne l'étant pas ou, du moins, pratiquement pas, alors qu'à travers la voie de couplage (L), la seconde longueur d'onde (λ₂) est susceptible d'être transmise entre la troisième porte (43) et la deuxième porte (42), la première longueur d'onde (λ₁) ne l'étant pas ou, du moins, pratiquement pas.

4. Dispositif selon la revendication 3, caractérisé en ce que le coupleur directif (400) comporte un guide d'onde (410) qui s'étend de façon rectiligne dans la voie de couplage (L) et qui est montéé entre la première porte (41) et la troisième porte (43) du dispositif de couplage (4), et un deuxième guide d'onde (420) disposé dans la voie de couplage (L), à faible distance (d) du guide d'onde (410) qui s'y étend de façon rectiligne, et qui s'étend avec des ondulations le long de la voie de couplage (L) pour mener vers la deuxième porte (42).

5. Dispositif selon l'une des revendications précédentes, caractérisé en ce que le dispositif de filtre (5) à sélection de longueur d'onde est constitué d'un réseau de Bragg (50) réalisé sur le guide d'ondes (402, 420) menant au détecteur (3).

6. Dispositif selon la revendication 5, caractérisé en ce que le réseau de Bragg (50) comporte au moins une ligne de réseau (51), qui est perpendiculaire à la direction de propagation (52) de la lumière guidée dans le guide d'onde (402,420) qui mène au détecteur (3).

7. Dispositif selon la revendication 5 ou 6, caractérisé en ce que le réseau de Bragg (50) est disposé sur la seconde branche (402) de la fourche de guide d'onde (40), ou sur le deuxième guide d'onde (420) du coupleur directif (400), à l'extérieur de sa voie de couplage (L).

8. Dispositif selon l'une des revendications 5 à 7, caractérisé en ce que le laser (2) est un laser DFB à réseau optique (20), et en ce que le réseau (20) du laser (2) et le réseau de Bragg (50) sont appliqués au guide d'onde (402) menant au détecteur (4) sur une couche commune (10 ou 11) sur ou au-dessus du substrat (1).

9. Dispositif selon la revendication 8, caractérisé en ce que le réseau (20) du laser (2) et le réseau de Bragg (50), appliqué au guide d'onde (402) menant au détecteur (3), sont formé par un seul réseau (60) dont les lignes de réseau (51,61) s'étendent en éventail depuis le réseau (20) du laser (2) en direction du réseau de Bragg (50).

10. Dispositif selon la revendication 8 ou 9, caractérisé en ce que le réseau (20) du laser (2) et le réseau de Bragg (50) réalisé sur le guide d'onde (402) menant au détecteur (3), sont formés sur une couche tampon (10) qui sépare le substrat (1) d'une couche (14), qui comprend ou forme le guide d'onde (402, 401, 403; 420, 430) du dispositif, et en ce qu'une couche (13) du laser qui possède une activité laser est disposée sur son réseau (20).

11. Dispositif selon l'une des revendications 8 à 10, notamment selon la revendication 10, caractérisé en ce qu'il est prévu une couche intermédiaire (200) entre une structure de couches (11, 12) du laser (2) à graver et le ou les réseaux (60, 20, 50).
